## Europäisches Patentamt
## European Patent Office
## Office européen des brevets

(19)

(11) Numéro de publication : **0 205 469**
**B1**

(12) **FASCICULE DE BREVET EUROPÉEN**

(45) Date de publication du fascicule du brevet :
**09.08.89**

(21) Numéro de dépôt : **85905844.8**

(22) Date de dépôt : **29.11.85**

(86) Numéro de dépôt international :
**PCT/FR 85/00342**

(87) Numéro de publication internationale :
**WO/8603857 (03.07.86 Gazette 86/14)**

(51) Int. Cl.⁴ : $G\ 05\ F\ \ 7/00$, $G\ 01\ N\ 24/06$, $H\ 01\ F\ \ 7/20$

(54) REGULATION DE CHAMP D'UN AIMANT.

(30) Priorité : **14.12.84 FR 8419190**

(43) Date de publication de la demande :
**30.12.86 Bulletin 86/52**

(45) Mention de la délivrance du brevet :
**09.08.89 Bulletin 89/32**

(84) Etats contractants désignés :
**DE GB NL**

(56) Documents cités :
**DE–A– 2 921 253**
**FR–A– 2 278 113**
**IEEE Transactions on Magnetics, vol. MAG-17, no. 5, September 1981, New York (US), H.J. Schneider·Muntau: "Polyhelix magnets", pp. 1775-1778**

(73) Titulaire : **GENERAL ELECTRIC CGR SA**
**100, rue Camille Desmoulins**
**F-92137 ISSY LES MOULINEAUX (FR)**

(72) Inventeur : **AUBERT, Guy**
**26, cours de la Libération**
**F-38100 Grenoble (FR)**
Inventeur : **KAPLAN, Daniel**
**6, rue Amyot**
**F-75007 Paris (FR)**

(74) Mandataire : **Ballot, Paul Denis Jacques et al**
**Cabinet Ballot-Schmit 84, avenue Kléber**
**F-75116 Paris (FR)**

# EP 0 205 469 B1

## Description

L'invention concerne un procédé de régulation du champ magnétique délivré par un aimant résistif pour éliminer toute dérive de ce champ due notamment aux variations de température provoquées principalement par la dissipation par effet Joule de l'aimant lui-même ; l'invention concerne aussi un système d'aimant résistif mettant en œuvre ce procédé et, à titre d'application, une installation d'imagerie par Résonance Magnétique Nucléaire (RMN) incorporant un tel système.

On sait que les installations d'imagerie par RMN, entre autres, nécessitent un aimant de grandes dimensions capable d'engendrer un champ magnétique uniforme, dit : champ de base, dans une région déterminée de l'espace. Typiquement, il est nécessaire d'engendrer un champ de 0,15 à 0,5 teslas avec une homogénéïté de 1 à 10 parties par million (ppm) dans une sphère de 50 cm de diamètre au moins.

Parmi les différents types d'aimants couramment utilisés pour créer de tels champs, on peut citer les aimants résistifs constitués d'une ou plusieurs bobines agencées, le plus souvent sans carcasse ferromagnétique, pour obtenir l'homogénéïté requise. La stabilisation du point de fonctionnement d'un tel aimant nécessite un temps considérable car il est impossible de déterminer la valeur du champ au centre de la « sphère d'homogénéïté » parce que ce volume est réservé au patient et qu'on ne peut y installer des moyens de mesure du champ et surtout parce que, en fonctionnement, le champ magnétique est perturbé par les champs annexes engendrés par les bobines de gradients de l'installation d'imagerie par RMN.

La stabilité et l'uniformité du champ magnétique ne sont donc réellement acquises que lorsque la température de l'aimant s'est complètement stabilisée, ce qui n'exclut pas des dérives ultérieures, difficiles à maîtriser. Toutes ces difficultés font qu'il n'a jamais été question jusqu'à présent de considérer la valeur du champ de base comme un paramètre susceptible d'être choisi par l'opérateur, en imagerie RMN.

L'invention a pour but de résoudre tous les inconvénients de la technique antérieure mentionnés ci-dessus.

Dans cet esprit, l'invention concerne un procédé de régulation du champ magnétique délivré par un aimant résistif principal refroidi par une circulation de fluide et créant un champ d'homogénéïté requise dans une région déterminée de l'espace, caractérisé en ce qu'il consiste :

à alimenter électriquement un aimant auxiliaire et l'aimant principal, par une source de courant continu commune, réglable,

à mettre ledit aimant auxiliaire en contact thermique avec du fluide précité de façon que ledit aimant auxiliaire soit sensiblement à la température dudit aimant principal,

à mesurer le champ magnétique témoin créé par ledit aimant auxiliaire, ce champ témoin étant représentatif dudit champ principal et

à régler ladite source de courant continu commune aux deux aimants pour asservir ledit champ témoin à une valeur choisie.

De préférence, les deux aimants sont connectés en série et on fait varier la valeur du courant qui les traverse.

Selon une autre caractéristique importante de l'invention, on mesure le champ magnétique témoin par exploitation du phénomène de résonance magnétique nucléaire sur un échantillon d'atomes choisis, placé dans une zone dudit champ magnétique témoin où celui-ci a une homogénéïté suffisante pour l'exploitation dudit phénomène.

Des « sondes à RMN » renfermant l'échantillon d'atomes choisis précité sont connues et proposées dans le commerce. Il est souhaitable que l'homogénéïté du champ magnétique témoin soit grande (comparable à celle du champ de l'aimant principal) dans toute la zone occupée par l'échantillon pour que le phénomène de RMN résultant concerne le plus grand nombre possible de noyaux de l'échantillon et donne lieu à un phénomène détectable, les conditions de résonance magnétique étant comme on sait directement liées à la valeur du champ magnétique et à celle de la fréquence d'excitation des noyaux.

L'invention concerne aussi un système d'aimant résistif, notamment pour engendrer un champ d'homogénéïté requise dans une région déterminée de l'espace, du type comportant un aimant résistif principal thermiquement couplé à un circuit de circulation de fluide de refroidissement et des moyens d'alimentation électrique de cet aimant, caractérisé en ce qu'il comporte en outre un aimant auxiliaire thermiquement couplé audit circuit de circulation de fluide de refroidissement et alimenté par lesdits moyens d'alimentation électrique, ledit aimant auxiliaire étant de faibles dimensions comparativement audit aimant principal pour créer un champ témoin représentatif du champ dudit aimant principal dans un volume restreint, en ce qu'il comporte en outre des moyens de mesure du champ témoin placés dans ledit volume restreint et une chaîne d'asservissement desdits moyens d'alimentation, pilotée par lesdits moyens de mesure dudit champ témoin pour asservir ledit champ témoin à une valeur choisie.

De préférence, l'aimant principal précité à une structure d'aimant de Bitter et les bobines de l'aimant principal et de l'aimant auxiliaire sont réalisées dans le même matériau conducteur, notamment le cuivre ou l'aluminium.

L'invention concerne en outre, à titre d'application, une installation d'imagerie par RMN, comportant

2

un système d'aimant résistif pour engendrer un champ magnétique de base d'homogénéïté requise dans une région déterminée de l'espace, un système de bobines de gradient pour superposer audit champ de base des gradients de champ d'intensités et d'orientations différentes prédéterminées pendant les séquences choisies, des moyens d'émission-réception radiofréquence pour émettre et recevoir des signaux radiofréquences dans ladite région de l'espace au cours desdites séquences et des moyens de calcul pour reconstituer une image à partir des signaux radiofréquence reçus par lesdits moyens d'émission-réception, ledit système d'aimant résistif comportant un aimant résistif principal thermiquement couplé à un circuit de circulation de fluide de refroidissement et des moyens d'alimentation électrique de cet aimant, installation caractérisée en ce que ledit système d'aimant résistif comporte en outre un aimant auxiliaire thermiquement couplé audit circuit de circulation de fluide de refroidissement et électriquement alimenté par lesdits moyens d'alimentation électrique, ledit aimant auxiliaire étant de faibles dimensions comparativement audit aimant principal pour créer un champ témoin représentatif du champ principal dans un volume restreint, en ce qu'il comporte en outre des moyens de mesure du champ témoin placés dans ledit volume restreint, et une chaîne d'asservissement desdits moyens d'alimentation, pilotée par lesdits moyens de mesure du champ témoin, en ce que la valeur de consigne de ladite chaîne d'asservissement est règlable pour engendrer plusieurs valeurs de champ de base et en ce que lesdits moyens d'émission-réception radiofréquence sont agencés pour fonctionner à des fréquences différentes correspondant respectivement aux valeurs de champ de base de façon à obtenir des images acquises à partir des conditions de RMN différentes.

On a en effet pu vérifier qu'avec le système d'aimant décrit ci-dessus, la stabilisation du champ magnétique était obtenue en quelques minutes ; on peut donc envisager d'acquérir des images avec des valeurs de champ de base différentes prédéterminées, en complètant l'appareillage habituel d'une installation de RMN, notamment les moyens d'émission-réception qui doivent pouvoir fonctionner à des fréquences différentes correspondant aux conditions de RMN, pour les différentes valeurs du champ de base, pour pouvoir obtenir, au cours d'un même examen, des images semblables du patient acquises à peu de temps d'intervalle à partir de conditions de RMN différentes. Ceci permet d'augmenter considérablement les possibilités de diagnostic en choisissant les conditions de RMN les mieux adaptées à la région du corps en examen et/ou en comparant les images obtenues à partir de conditions de RMN différentes.

L'invention sera mieux comprise et d'autres avantages de celle-ci apparaîtront mieux à la lumière de la description qui va suivre, donnée uniquement à titre d'exemple et faite en référence aux dessins annexés dans lesquels :

la figure 1 est un schéma-bloc du système d'aimant conforme aux principes de l'invention ;

la figure 2 est une vue de détail de l'installation montrant la structure de l'aimant auxiliaire, en coupe longitudinale ;

la figure 3 est une coupe III-III de cet aimant auxiliaire ;

la figure 4 est une vue de détail des spires de l'aimant auxiliaire ;

la figure 5 est un schéma bloc d'une installation d'imagerie par RMN incorporant le système d'aimant de la figure 1.

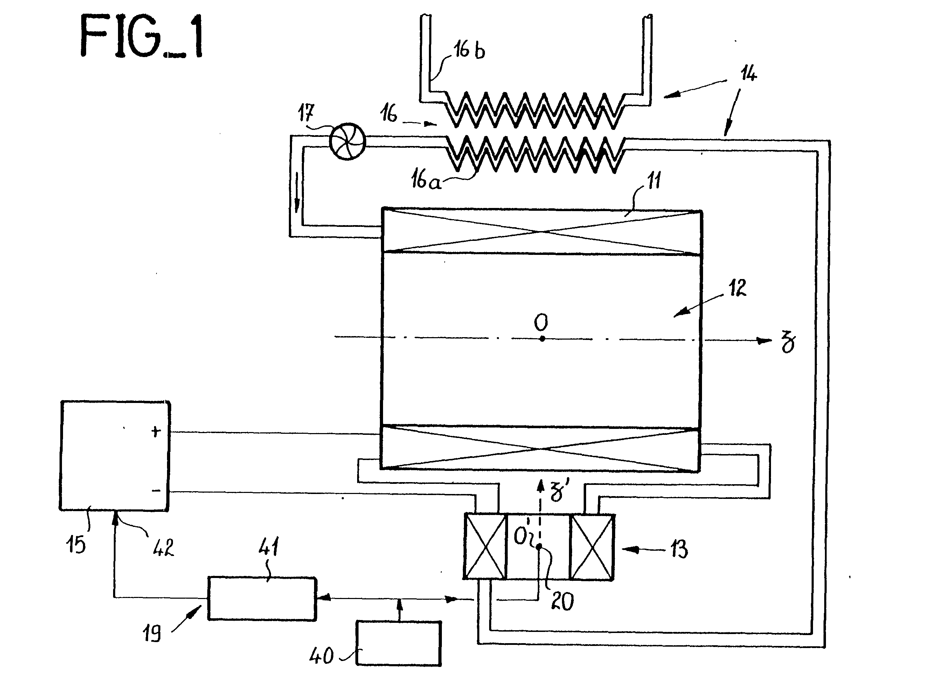

Le système représenté à la figure 1 se compose essentiellement d'un aimant résistif 11 de grandes dimensions, conçu pour créer un champ magnétique relativement intense et très homogène dans la région 12 de son volume interne, d'un aimant auxiliaire 13 de petites dimensions, d'un circuit de circulation de fluide de refroidissement 14 en contact thermique avec les aimants 11 et 13, et d'une source de courant continu 15, asservie, connectée en série avec les bobines des deux aimants.

Comme mentionné précédemment, pour une application à l'imagerie RMN, l'aimant 11 est conçu pour engendrer un champ magnétique compris entre 0,15 et 0,5 teslas dans une sphère de 50 cm de diamètre de centre O (le centre de symétrie de l'aimant) avec une homogénéïté de 1 à 10 ppm.

De préférence, l'aimant principal 11 comporte au moins une bobine de Bitter. On entend par « bobine de Bitter » une bobine constituée de disques annulaires métalliques (typiquement en cuivre ou en aluminium) définissant des spires d'un solénoïde, ces disques étant électriquement isolés les uns des autres (le plus souvent avec interposition de feuilles isolantes de forme semblable) mais connectés bout à bout pour matérialiser ledit solénoïde, tandis que des trous pratiqués dans les anneaux et les isolants définissent des canaux s'étendant sensiblement parallèlement à l'axe longitudinal du solénoïde et dans lesquels circule le fluide de refroidissement.

Dans tous les cas, l'aimant 11 a une structure permettant un échange thermique efficace entre les enroulements de la ou les bobines résistives le constituant et le fluide de refroidissement. Il en est de même de l'aimant 13 qui est agencé, comme on le verra plus loin, pour recevoir le même fluide de refroidissement de façon à être toujours sensiblement à la même température que l'aimant principal. Il est à noter à ce propos que la résistance interne de l'aimant auxiliaire est très faible par rapport à celle de l'aimant principal de sorte que sa contribution à l'échauffement du fluide circulant dans le circuit 14 soit pratiquement négligeable. En outre, les bobines des deux aimants 11 et 13 sont réalisées dans le même matériau conducteur, notamment le cuivre ou l'aluminium.

Le circuit 14 comporte en outre une pompe de circulation 17 et un échangeur 16 dont le circuit secondaire 16b est traversé par ledit fluide de refroidissement et dont le circuit primaire 16a est alimenté par de l'eau froide en circulation. Dans l'exemple représenté, le circuit 14 est conçu pour que la totalité du fluide de refroidissement traverse l'aimant auxiliaire 13, mais il est envisageable, par une dérivation appropriée, de ne faire circuler qu'une partie de ce fluide dans l'aimant 13 pour autant que la température de ce dernier soit toujours sensiblement égale à celle de l'aimant 11, à tout moment. Dans cet esprit, il est particulièrement important que le circuit 14 soit agencé de telle sorte que le fluide entrant dans l'aimant 13 provienne directement de l'aimant principal 11, sans passer par l'échangeur 16.

Par ailleurs, comme mentionné précédemment, les bobines des aimants 11 et 13 sont, à tout moment, traversées par le même courant délivré par la source de courant 15. L'aimant 13 a pour fonction de créer un champ magnétique témoin représentatif du champ de l'aimant principal dans au moins un volume restreint de son espace interne où sont placés des moyens de mesure dudit champ témoin, pour piloter une chaîne d'asservissement 19 du courant délivré par la source de courant continu 15. Selon un mode de réalisation préféré, ces moyens de mesure de champ comportent une sonde de RMN 20 pour piloter la chaîne d'asservissement 19, ladite sonde étant placée dans ledit volume restreint. Pour obtenir un signal de RMN exploitable, l'aimant auxiliaire 13 est construit pour que le champ témoin soit d'homogénéité suffisante dans le volume restreint où se trouve placée la sonde. En pratique, l'homogénéité du champ témoin dans le volume environnant de la sonde doit être de 1 à 10 ppm, c'est-à-dire du même ordre de grandeur que l'homogénéité du champ de base dans le volume utile de l'aimant principal.

Les aimants 11 et 13 admettent chacun un axe longitudinal de symétrie, respectivement Oz et O'z', O et O' étant les centres de symétrie de ces aimants. Selon une caractéristique avantageuse de l'invention, l'axe O'z' de l'aimant auxiliaire 13 est sensiblement placé dans un plan transversal médian (contenant le point O) de l'aimant principal 11 de façon à couper l'axe Oz au point O, l'aimant 13 restant bien entendu extérieur à l'aimant 11. Cet agencement est celui qui offre le couplage parasite le plus faible possible entre les deux aimants et qui perturbe donc le moins l'homogénéité des deux champs.

Avec le système décrit ci-dessus, le courant délivré par la source de courant continu 15 est ajusté en permanence pour réguler la valeur du champ bo dans l'aimant 13. Ce champ est de la forme :

$$bo = b(1 + a\ T)I$$

où T est la température, I le courant et a, b des constantes.

Cependant, avec les conditions énoncées ci-dessus, le champ de base Bo est aussi de la forme :

$$Bo = B(1 + a\ T)I$$

a et B étant des constantes.

Par conséquent :

$$Bo/bo = c^{te}$$

La régulation du champ bo entraîne donc la régulation du champ Bo. Une régulation du même type peut être obtenue avec les aimants branchés en parallèle et connectés à une source de courant continu asservie de façon analogue.

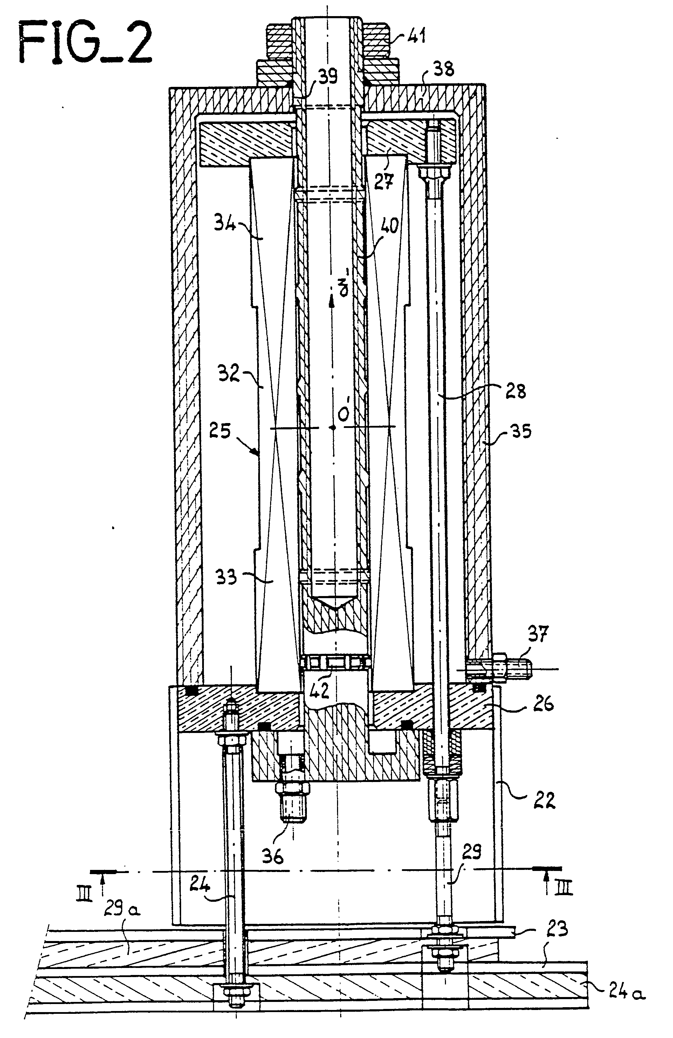

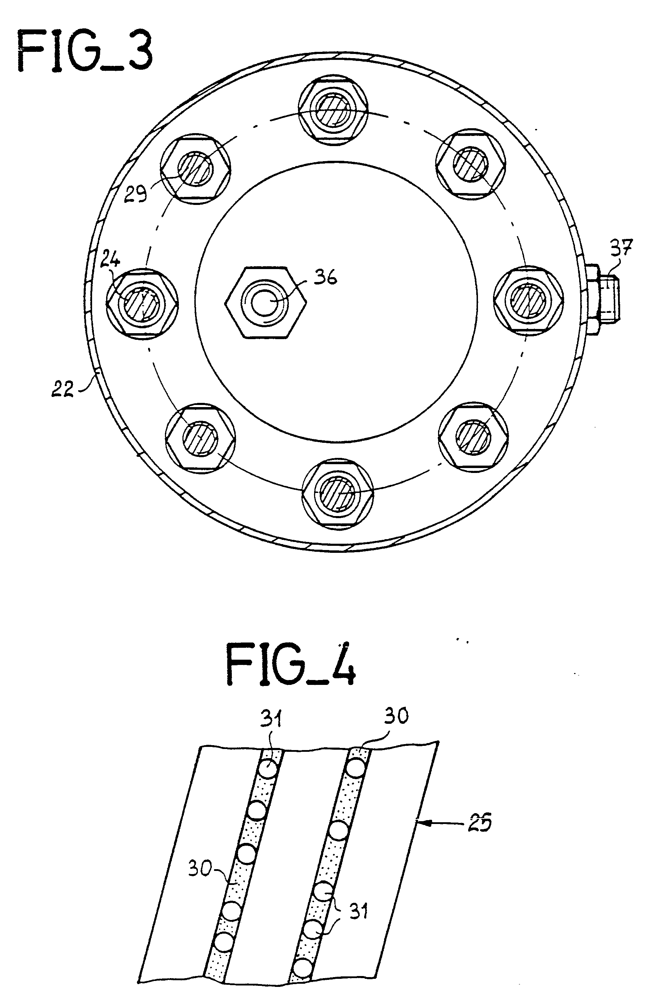

On va maintenant décrire, en référence aux figures 2 à 4, la structure d'un aimant auxiliaire convenant pour l'application envisagée. Cet aimant est constitué d'une bobine 25 à spires hélicoïdales serrées entre deux flasques métalliques d'extrémité 26, 27 (formant des plateaux annulaires répartiteurs de courant) au moyen de tirants 28 régulièrement répartis sur une surface cylindrique coaxiale à l'axe O'z'. Les tirants 28 sont en contact électrique avec le flasque 27 et électriquement isolés de la bobine 25 et du flasque 26. Le flasque 26 est électriquement reliée par autant de tiges métalliques 24 qu'il y a de tirants à une pièce de raccordement électrique 24a. Ces tiges sont disposées sur la même surface cylindrique que les tirants 28 et sont équidistantes de ceux-ci (voir figure 3). Les extrémités des tirants 28 sont prolongées par autant de tiges 29 métalliques électriquement connectées à une autre pièce de raccordement électrique 29a parallèle à la pièce 24a. Les tiges 24 sont isolées de la pièce 29a qu'elles traversent. Les courants circulent en sens inverse dans les tiges 24, 29 et les pièces 24a, 29a de sorte que, le champ magnétique qu'ils créent au voisinage du centre O' de l'aimant, est négligeable. Des plaques de matériau isolant 23 sont intercalées entre le socle 22 de l'aimant auxiliaire et la pièce 29a, d'une part et entre les pièces 29a et 24a, d'autre part. Les tirants 28 participent au raccordement électrique de la bobine 25, tout en compensant sa composante axiale de courant due au pas d'hélice de l'enroulement.

Structurellement, la bobine 25 résulte de l'usinage d'une hélice dans une portion tubulaire cylindrique du métal choisi (plus longue que la bobine désirée) et de la compression axiale de cette hélice pour réaliser une bobine à spires jointives. Ces spires sont collées entre elles par une colle isolante 30 dans laquelle sont incorporées de petites billes de verre calibrées 31 maintenant un très faible écartement diélectrique constant entre spires adjacentes (voir figure 4). Pour homogénéiser le champ témoin dans une zone autour du centre O', suffisante pour accueillir la sonde de RMN 20, on a modifié la section des spires centrales par rapport aux spires d'extrémité. Pour cela, on a usiné la portion centrale 32 de la bobine de façon à lui donner un diamètre extérieur plus faible que celui des deux portions d'extrémité adjacentes 33, 34. La longueur de la portion centrale 32 et la différence des diamètres sont choisies pour obtenir l'homogénéité requise. La bobine qui vient d'être décrite est logée dans un boîtier étanche 35 muni d'orifices de raccordement 36, 37, pour son insertion dans le circuit de fluide de refroidissement 14.

Plus précisément, le boîtier 35, cylindrique, en matériau isolant, est complètement ouvert à l'une de ses extrémités axiales et cette extrémité repose sur le bord du flasque 26, lequel est plus grand que le flasque 27. L'autre extrémité axiale du boîtier comporte une paroi 38 percée d'un trou 39 pour le passage d'un mandrin creux 40, isolant, à l'intérieur duquel sera logée la sonde 20. Ce mandrin comporte un épaulement à une extrémité, prenant appui contre la surface externe du flasque 26 et dans lequel est ménagé l'orifice 36. Son autre extrémité comporte une partie filetée faisant saillie hors du trou 39 et un écrou 41 est engagé sur cette partie filetée, son serrage provoquant la fermeture étanche du boîtier 35. Le mandrin 40 comporte à sa surface externe des reliefs annulaires cannelés 42, maintenant un passage annulaire pour l'écoulement du fluide entre le mandrin et la surface interne de la bobine 25. Comme l'orifice 37 est ménagé dans la paroi latérale du boîtier 35, le fluide est en contact thermique avec les parois internes et externes de la bobine 25 de sorte que cette dernière se trouve toujours à la température du fluide de refroidissement.

A titre d'exemple, un aimant tel que représenté aux figures 2 à 4, et possédant les qualités d'homogénéité de champ requises, comporte une bobine 25 en cuivre ayant les caractéristiques suivantes :

longueur totale : 310 mm
diamètre interne : 38 mm
longueur de la portion centrale : 137,54 mm
diamètre externe de la portion centrale : 81,42 mm
diamètre externe des portions d'extrémités : 92 mm

La chaîne d'asservissement 19 est classique et ses constituants sont disponibles dans le commerce, notamment pour les applications de spectrométrie. La sonde de RMN 20 comporte une bobine de couplage entourant l'échantillon mentionné ci-dessus et la chaîne d'asservissement 19 comporte essentiellement un générateur radio-fréquence 40 alimentant la bobine de couplage et émettant un signal à fréquence variable dans le temps. Un balayage d'une certaine plage de fréquence incluant la fréquence de RMN est donc appliqué à la sonde. Par ailleurs, la chaîne d'asservissement 19 comporte aussi des moyens de mesure 41 du signal radio-fréquence aux bornes de ladite bobine de couplage. Lorsque le générateur est à la fréquence de RMN de l'échantillon, un phénomène d'absorption d'énergie se produit, et le signal radio-fréquence, aux bornes de la bobine, est très fortement atténué. La dérivée du signal d'absorption est comparée à une référence pour élaborer le signal d'erreur appliqué à l'entrée de pilotage 42 de la source d'alimentation 15. Le balayage à fréquence variable est répété régulièrement de façon à constamment réactualiser la valeur du signal d'erreur appliqué à l'entrée de pilotage 42.

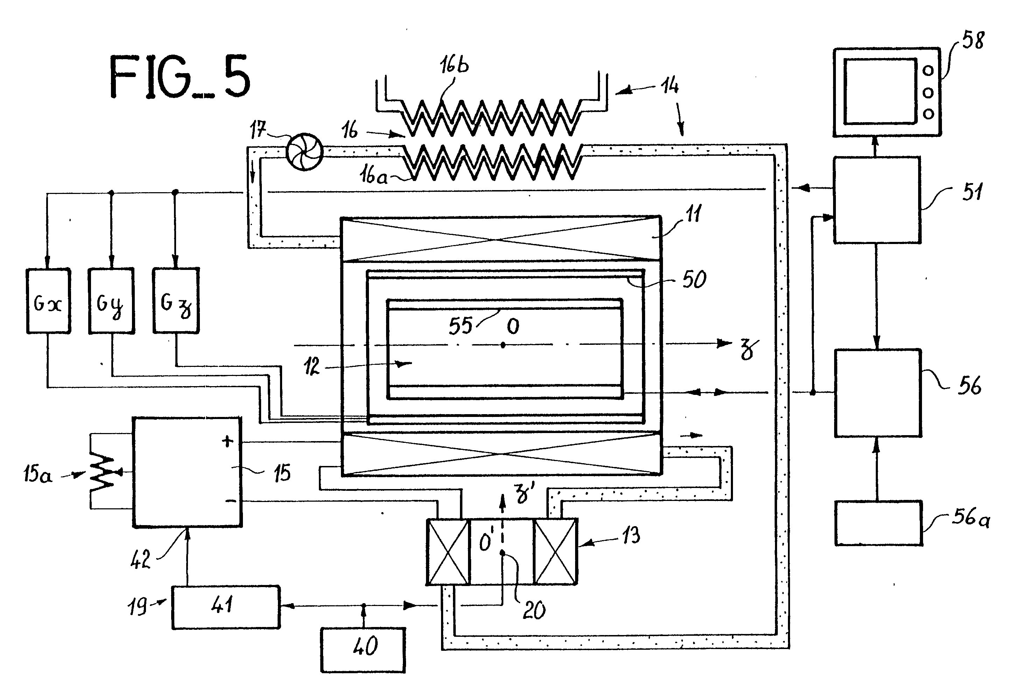

On va maintenant décrire brièvement, en référence à la figure 5, une installation d'imagerie par RMN incorporant un système d'aimant décrit en référence aux figures 1 à 4, pour l'élaboration du champ de base. Les éléments de structure analogues portent les mêmes références numériques et ne seront pas décrits à nouveau. L'installation est aussi pourvue d'un système de bobinages de correction (appelés « shims ») connu en soi et non représenté, essentiellement destiné à compenser les effets perturbateurs de l'environnement de l'aimant. L'aimant 11 chargé d'élaborer le champ de base est associé à un système de bobines de gradients 50, connu en soi, les bobines de gradients sont agencées sur un mandrin tubulaire cyclindrique placé à l'intérieur de l'espace interne 12 de l'aimant 11, coaxialement à l'axe Oz. Le système de bobines de gradients est complété par un ensemble d'alimentations en courant continu (Gx, Gy, Gz) commandées suivant un cycle de séquences préprogrammées dans un ordinateur 51 pour alimenter les bobines de gradients de façon à superposer au champ de base des gradients de champ magnétique d'intensités et d'orientations différentes prédéterminées au cours desdites séquences. On sait que ces gradients permettent, entre autres, de sélectionner le plan de coupe dont on désire reconstruire l'image. Un système d'antennes radio-fréquence 55 est également logé à l'intérieur de l'espace utile 12 de l'aimant 11. Ces antennes font partie de moyens d'émission-réception radio-fréquence, comportant en outre un générateur radio-fréquence 56 piloté par l'ordinateur 51 pour engendrer des impulsions calibrées de signal radio-fréquence pendant lesdites séquences. Les signaux de RMN réémis par le sujet en cours d'examen sont captés par le même système d'antennes et exploités par une unité de calcul de l'ordinateur 51, appliquant des algorithmes connus pour reconstituer une image. Cette image est par exemple affichée sur un tube cathodique d'un récepteur de télévision 58.

Selon l'invention, on peut, au cours de l'examen d'un même patient, acquérir les informations nécessaires à la reconstruction de plusieurs images semblables (c'est-à-dire de plusieurs images d'une même coupe du sujet) à la condition que la source de courant 15 soit pourvue de moyens de réglage 15a de sa valeur de consigne, pour pouvoir faire fonctionner l'aimant 11 à des valeurs de champ magnétique de bases différentes, choisies. Bien entendu, comme les conditions de RMN pour une valeur de champ magnétique donnée imposent une fréquence d'émission donnée, les moyens d'émission-réception et particulièrement le générateur 56, sont aussi agencés pour fonctionner à des fréquences différentes. Le générateur doit donc comporter un moyen de commande 56a permettant de la faire osciller à une fréquence correspondant à la valeur du champ de base choisie. La conception de sous-ensembles tels que la source de courant à consigne variable et le générateur radio-fréquence à fréquence ajustable est à la portée de l'homme du métier. Ce progrès est important dans l'imagerie RMN puisqu'il permet, d'une part de choisir les conditions RMN les mieux adaptées à la nature des tissus dans la coupe du patient que l'on examine, et d'autre part de comparer des images semblables obtenues dans des conditions de RMN différentes à peu de temps d'intervalle, pour améliorer le diagnostic. Ce progrès a été rendu possible par le fait que la stabilisation du champ de base dans l'espace interne 12 de l'aimant 11 est extrêmement rapide (quelques minutes alors qu'il fallait des heures auparavant) ce qui permet de changer la valeur du champ de base sans que l'installation soit inutilisable pendant de longues périodes et d'acquérir des images semblables sans que le séjour du patient dans l'espace 12 ne dure trop longtemps.

## Revendications

1. Procédé de régulation du champ magnétique délivré par un aimant résistif principal refroidi par une circulation de fluide et créant un champ d'homogénéité requise dans une région déterminée de l'espace, caractérisé en ce qu'il consiste :
   à alimenter électriquement un aimant auxiliaire (13) et l'aimant principal (11), par une source de courant continu commune (15) réglable,
   à mettre ledit aimant auxiliaire en contact thermique (14) avec du fluide précité de façon que ledit aimant auxiliaire soit sensiblement à la température dudit aimant principal,
   à mesurer par des moyens de mesure (20) le champ magnétique témoin créé par ledit aimant auxiliaire, ce champ témoin étant représentatif dudit champ principal et
   à régler ladite source de courant continu commune aux deux aimants pour asservir ledit champ témoin à une valeur choisie.

2. Procédé de régulation selon la revendication 1, caractérisé en ce que les deux aimants sont connectés en série et qu'on règle la valeur du courant qui les traverse pour asservir ledit champ témoin.

3. Procédé de régulation selon la revendication 1, caractérisé en ce qu'on mesure ledit champ magnétique témoin par exploitation du phénomène de Résonance Magnétique Nucléaire avec lesdits moyens de mesure renfermant un échantillon d'atomes choisis, placé dans une zone dudit champ magnétique témoin où celui-ci a une homogénéité suffisante pour l'exploitation dudit phénomène.

4. Système d'aimant résistif, notamment pour engendrer un champ d'homogénéité requise dans une région déterminée de l'espace, du type comportant un aimant résistif principal (11) thermiquement couplé à un circuit de circulation de fluide de refroidissement (14) et des moyens d'alimentation électrique (15) de cet aimant, caractérisé en ce qu'il comporte en outre un aimant auxiliaire (13) thermiquement couplé audit circuit de circulation de fluide de refroidissement et électriquement alimenté par lesdits moyens d'alimentation électrique, ledit aimant auxiliaire étant de faibles dimensions comparativement audit aimant principal pour créer un champ témoin représentatif du champ principal dans un volume restreint, en ce qu'il comporte en outre des moyens de mesure (20) du champ témoin placés dans ledit volume restreint et une chaîne d'asservissement desdits moyens d'alimentation, pilotée par lesdits moyens de mesure du champ témoin pour asservir ledit champ témoin à une valeur choisie.

5. Système selon la revendication 4, caractérisé en ce que les deux aimants (11, 15) sont électriquement connectés en série, ladite chaîne d'asservissement réglant le courant délivré par lesdits moyens d'alimentation électrique.

6. Système selon la revendication 4 ou 5, caractérisé en ce que le circuit de circulation de fluide (14) est agencé pour refroidir ledit aimant principal (11) et pour faire passer au moins une partie dudit fluide réchauffé par ledit aimant principal en contact thermique avec ledit aimant auxiliaire (13) pour porter celui-ci à sensiblement la même température que celle de l'aimant principal.

7. Système selon la revendication 4, caractérisé en ce que ledit aimant auxiliaire est construit pour que le champ témoin dans ledit volume réduit soit d'homogénéité suffisante pour l'exploitation d'un phénomène RMN, et que lesdits moyens de mesure du champ témoin comprennent une sonde de RMN (20) renfermant un échantillon d'atomes choisis.

8. Système selon l'une des revendications 4 à 7, caractérisé en ce que ledit aimant principal (11) et ledit aimant auxiliaire (13) admettant chacun un axe longitudinal de symétrie, l'axe dudit aimant auxiliaire (O'z') est sensiblement placé dans un plan transversal médian dudit aimant principal, de façon à couper l'axe (Oz) de ce dernier.

9. Système selon l'une des revendications 4 à 8, caractérisé en ce que les bobines de l'aimant principal et de l'aimant auxiliaire sont réalisées dans le même matériau conducteur, notamment le cuivre ou l'aluminium.

10. Système selon l'une des revendications 4 à 9, caractérisé en ce que l'aimant principal (11) précité se compose essentiellement d'une ou plusieurs bobines de Bitter.

11. Système selon l'une des revendications 4 à 10, caractérisé en ce que ledit aimant auxiliaire comporte une bobine (25) à spires hélicoïdales, serrée entre deux flasques métalliques (26, 27) d'extrémité par des tirants (28) régulièrement répartis sur une surface cylindrique coaxiale à l'axe (O'z') de ladite bobine et en ce que ces tirants sont en contact électrique avec l'un (27) des flasques et électriquement isolés de ladite bobine (25) et de l'autre flasque (26), pour participer au raccordement

6

électrique de ladite bobine tout en compensant la composante axiale du vecteur courant due au pas d'hélice de ladite bobine.

12. Système selon la revendication 11, caractérisé en ce que ladite bobine (25) à spires hélicoïdales résulte de l'usinage d'une hélice dans une portion tubulaire cylindrique et de la compression axiale de cette hélice.

13. Système selon la revendication 11 ou 12, caractérisé en ce que les spires de ladite bobine sont collées entre elles avec une colle isolante comportant des billes de verre (31) calibrées.

14. Système selon l'une des revendications 12 ou 13, caractérisé en ce qu'une portion centrale (32) de ladite bobine a un diamètre extérieur plus faible que celui des deux portions d'extrémité (33, 34) adjacentes, pour améliorer l'homogénéïté dudit champ témoin à l'intérieur de ladite bobine.

15. Installation d'imagerie par RMN, comportant un système d'aimant résistif pour engendrer un champ magnétique de base d'homogénéité requise dans une région déterminée de l'espace, un système de bobines de gradient (50) pour superposer audit champ de base des gradients de champ d'intensités et d'orientations différentes prédéterminées pendant des séquences choisies, des moyens d'émission-réception radiofréquence (55, 56) pour émettre et recevoir des signaux radiofréquence dans ladite région de l'espace au cours desdites séquences et des moyens de calcul (51) pour reconstituer une image à partir des signaux radiofréquence reçus par lesdits moyens d'émission-réception, ledit système d'aimant résistif comportant un aimant résistif principal (11) thermiquement couplé à un circuit de circulation de fluide de refroidissement (14) et des moyens d'alimentation électrique (15) de cet aimant, installation caractérisée en ce que ledit système d'aimant résistif comporte en outre un aimant auxiliaire (13) thermiquement couplé audit circuit de circulation de fluide de refroidissement et électriquement alimenté par lesdits moyens d'alimentation électrique (15), ledit aimant auxiliaire étant de faibles dimensions comparativement audit aimant principal pour créer un champ témoin représentatif dudit champ principal dans un volume restreint, en ce qu'il comporte en outre des moyens de mesure (20) du champ témoin placés dans ledit volume restreint et une chaîne d'asservissement (19) desdits moyens d'alimentation, pilotée par lesdits moyens de mesure du champ témoin, en ce que la valeur de consigne de ladite chaîne d'asservissement est réglable (15a) pour engendrer plusieurs valeurs de champ de base et en ce que lesdits moyens d'émission-réception radiofréquence sont agencés pour fonctionner à des fréquences différentes (56a) correspondant respectivement aux valeurs de champ de base précitées, de façon à obtenir des images acquises à partir de conditions de RMN différentes.

**Claims**

1. A method for automatically controlling the magnetic field supplied by a principal resistive magnet cooled by a circulation of fluid and creating a homogeneity field as required in a predetermined region of space, characterized in that it consists of :

electrically supplying an auxiliary magnet (13) and the principal magnet (11) with a controlled common source of DC (15),

placing the said auxiliary magnet in thermal contact (14) with some of the said fluid in such a manner that the said auxiliary magnet is substantially at the temperature of the said principal magnet,

using measuring means (20) to measure the pilot magnetic field, which is created by the said auxiliary magnet, said pilot field being representative of the said principal field and

automatically controlling the said source of DC common to the two magnets in order maintain the said pilot field at a selected value.

2. The automatic control method as claimed in claim 1, characterized in that the two magnets are connected in series and in that the value of the current which passes through them is automatically controlled in order to control the said pilot field.

3. The automatic control method as claimed in claim 1, characterized in that the said pilot magnetic field is measured by using the phenomenon of nuclear magnetic resonance with the said measuring means including a sample of selected atoms, placed in a zone of the said magnetic field where the latter has a sufficient homogeneity to make use of the said phenomenon.

4. A resistive magnet system, more especially to engender a homogeneity field required in a predetermined region of space, of the type comprising a principal resistive magnet (11) thermally coupled with a cooling fluid circulation system (14) and means (15) for electrically feeding this magnet, characterized in that it additionally comprises an auxiliary magnet (13) thermally coupled with the said cooling fluid circulation circuit and electrically supplied by the said electrical supply means, the said auxiliary magnet being of small dimensions in comparison with the said principal magnet in order to create a pilot field representative of the principal filed in a restricted volume, in that it furthermore comprises measurement means (20) for the pilot field placed in the said restricted volume and a feedback loop for the control of the said feed means, piloted by the said means for measuring the said pilot field in order to keep the said pilot field at a selected value.

5. The system as claimed in claim 4, characterized in that the two magnets (11 and 15) are electrically connected in series, the said feedback loop automatically controlling the current supplied by the electrical supply means.

6. The system as claimed in claim 4 or in claim 5, characterized in that the fluid circulation circuit (14) is operated in order to so cool the said principal magnet (11) as to cause at least a part of the said heated fluid to flow through the said principal magnet in thermal contact with the said auxiliary magnet (13), in order to put it at substantially the same temperature as the principal magnet.

7. The system as claimed in claim 4, characterized in that the said auxiliary magnet is so designed that the pilot field in the said reduced volume has a sufficient homogeneity for the use of the RMN phenomenon, and in that the said means for measuring the pilot field comprise an RMN probe (20) containing a sample of selected atoms.

8. The system as claimed in any one of the claims 4 through 7, characterized in that, the said principal magnet (11) and the said auxiliary magnet (13) each permitting a longitudinal axis of symmetry, the axis of the said auxiliary magnet (O'z') is substantially placed in a traverse median plane of the said principal magnet in such a manner as to intersect the axis (Oz) of the latter.

9. The system as claimed in any one of the claims 4 through 8, characterized in that the coils of the principal magnet are made of the same conducting material, more especially copper or aluminium.

10. The system as claimed in any one of the claims 4 through 9, characterized in that the said principal magnet (11) is substantially composed of one or more bitter coils.

11. The system as claimed in any one of the claims 4 through 10, characterized in that the said auxiliary magnet comprises a coil (25) with helicoidal turns, gripped between two metallic end flanges (26 and 27) by draw rods (28) regularly spaced over a cylindrical surface centered on the axis (O'z') of the said coil and in that the draw rods are in electrical contact with one (27) of the flanges and electrically insulated from the said coil (25) and the other flange (26) in order to participate in the electrical connection of the said coil while compensating the axial component of the current vector due to the pitch of the helix of the said coil.

12. The system as claimed in claim 11, characterized in that the said coil (25) with helicoidal turns is produced by machining a helix in a tubular cylindrical portion and the axial compression of the said helix.

13. The system as claimed in claim 11 or claim 12, characterized in that the turns of the said coil are bonded to each other using an insulating adhesive comprising calibrated glass spheres (31).

14. The system as claimed in any one of the claims 12 and 13, characterized in that a central portion (32) of the said coil has an external diameter smaller than that of the two adjacent end portions (33 and 34) in order to improve the homogeneity of the said pilot field inside the said coil.

15. An RMN imaging arrangement comprising a resistive magnet system in order to create a magnetic field with a base homogeneity required in a predetermined space, a gradient coil system (50) in order to superimpose, on the said base field, gradients with different predetermined intensities and orientations during selected sequences, RF transmitting receiving means (55 and 56) to transmit and receive the RF signals in the said region of the space in the course of the said sequences and calculating means (51) in order to reconstruct an image starting from the RF signals received by the said transmitting receiving means, the said resistive magnet system comprising a principal resistive magnet (11) thermally coupled with a cooling fluid circulation circuit (14) and means (15) for electrically supplying this magnet, said arrangement being characterized in that the said resistive magnet system furthermore comprises an auxiliary magnet (13) thermally coupled with the said cooling fluid circulation circuit and electrically supplied by the said electrical supply means (15), the said auxiliary magnet being of small dimensions in comparison with the said principal magnet in order to create a pilot field representative of the said principal field in a restricted volume, in that it furthermore comprises measurement means (20) for the pilot field placed in the said restricted volume and a feedback loop (19) for the said supply means, piloted by the said pilot field measuring means, in that the duty value of the said feedback loop (15a) is able to be varied in order to create several base field values and in that the said RF transmitting and receiving means are operated to function at different frequencies (56a) corresponding respectively to the said base field values in such manner as to obtain images based on different RMN conditions.

## Patentansprüche

1. Verfahren zur Stabilisierung des Magnetfeldes, das ein resistiver Hauptmagnet erzeugt, der durch eine Fluidströmung gekühlt wird und ein Feld erzeugt, das in einem bestimmten Raumbereich homogen sein soll, dadurch gekennzeichnet, daß es darin besteht:

einen Hilfsmagnet (13) sowie den Hauptmagnet (11) durch eine gemeinsame steuerbare Gleichstromquelle (15) elektrisch anzusteuern,

diesen Hilfsmagnet mit dem genannten Fluid in thermischen Kontakt (14) zu bringen, so daß dieser Hilfsmagnet im wesentlichen die Temperatur dieses Hauptmagnets aufweist,

unter Verwendung von Meßmitteln (20) das Indikatormagnetfeld zu messen, das für dieses Hauptfeld repräsentativ ist und durch diesen Hilfsmagnet erzeugt wird,

diese den beiden Magneten gemeinsame Gleichstromquelle nachzusteuern, um dieses Indikatorfeld einem ausgewählten Wert nachzuregeln.

2. Stabilisierungsverfahren nach Anspruch 1, dadurch gekennzeichnet, daß die beiden Magnete in Reihe geschaltet sind und daß der Wert des sie durchfließenden Stroms nachgesteuert wird, um dieses Indikatorfeld nachzuregeln.

3. Stabilisierungsverfahren nach Anspruch 1, dadurch gekennzeichnet, daß dieses Indikatormagnetfeld durch Ausnutzung des Phänomens der magnetischen Kernresonanz mit diesen Meßmitteln gemessen wird, welche eine Probe von ausgewählten Atomen enthalten, welche sich in einem Bereich dieses Indikatormagnetfeldes befindet, wo es ausreichend homogen ist, um dieses Phänomen auszunutzen.

4. System eines resistiven Magnets, insbesondere für die Erzeugung eines Feldes, das in einem bestimmten Raumbereich homogen sein soll, vom Typ mit einem resistiven Hauptmagnet (11), der an einen Kühlfluid-Kreislauf (14) thermisch angekoppelt ist, sowie mit Mitteln für die elektrische Stromversorgung (15) dieses Magnets, dadurch gekennzeichnet, daß es ferner einen Hilfsmagnet (13) umfaßt, der an diesen Kühlfluid-Kreislauf thermisch angekoppelt und durch diese Mittel für die elektrische Stromversorgung elektrisch versorgt ist, wobei dieser Hilfsmagnet in Vergleich zu diesem Hauptmagnet geringe Abmessungen aufweist, um ein Indikatorfeld zu erzeugen, das für das Hauptfeld in einem eingeschränkten Raum repräsentativ ist, daß es ferner Mittel (20) zum Messen des Indikatorfeldes, welche in diesem eingeschränkten Raum angeordnet sind, sowie eine Regelschleife für diese Versorgungsmittel umfaßt, welche durch diese Mittel zum Messen des Indikatorfeldes gesteuert wird, um dieses Indikatorfeld einem ausgewählten Wert nachzuregeln.

5. System nach Anspruch 4, dadurch gekennzeichnet, daß die beiden Magnete (11, 15) elektrisch in Reihe geschaltet sind, wobei diese Regelschleife den durch diese Mittel für die elektrische Versorgung abgegebenen Strom nachsteuert.

6. System nach Anspruch 4 oder 5, dadurch gekennzeichnet, daß der Kühlfluid-Kreislauf (14) ausgelegt ist, um diesen Hauptmagnet (11) abzukühlen sowie wenigstens einen Teil dieses erwärmten Fluids durch diesen mit diesem Hilfsmagnet (13) in thermischen Kontakt gebrachten Hauptmagnet durchfließen zu lassen, um diesen auf eine im wesentlichen gleiche Temperatur wie diejenige des Hauptmagnets zu bringen.

7. System nach Anspruch 4, dadurch gekennzeichnet, daß dieser Hilfsmagnet so ausgebildet ist, daß das Indikatorfeld in diesem eingeschränkten Raum für die Ausnutzung eines MKR-Phänomens ausreichend ist, und daß diese Mittel zum Messen des Indikatorfeldes eine MKR-Sonde (20) umfassen, welche eine Probe ausgewählter Atome enthält.

8. System nach einem der Ansprüche 4 bis 7, dadurch gekennzeichnet, daß der Hauptmagnet (11) und der Hilfsmagnet (13) eine Symmetrielängsachse aufweisen und die Achse (O′ z′) dieses Hilfsmagnets im wesentlichen in einer mittleren Querebene dieses Hauptmagnets derart gelegen ist, daß sie die Achse (Oz) dieses letzteren schneidet.

9. System nach einem der Ansprüche 4 bis 8, dadurch gekennzeichnet, daß die Spulen des Hauptmagnets sowie des Hilfsmagnets aus einem selben leitenden Material, insbesondere aus Kupfer oder Aluminium, bestehen.

10. System nach einem der Ansprüche 4 bis 9, dadurch gekennzeichnet, daß der genannte Hauptmagnet (11) im wesentlichen aus einer oder aus mehreren Bitter-Spulen besteht.

11. System nach einem der Ansprüche 4 bis 10, dadurch gekennzeichnet, daß der Hilfsmagnet eine Spule (25) mit schraubenförmigen Windungen umfaßt, welche zwischen zwei metallischen Endflanschen (26, 27) durch Zugstangen (28) eingespannt ist, welche auf einer zur Achse (O′ z′) dieser Spule koaxialen zylindrischen Fläche gleichmäßig verteilt sind, und daß diese Zugstangen mit einem (27) dieser Flansche in elektrischem Kontakt stehen sowie von dieser Spule (25) und von dem anderen Flansch (26) elektrisch isoliert sind, um zu dem elektrischen Anschluß dieser Spule beizutragen und dabei die axiale Komponente des Stromvektors, welche von der Schraubensteigung dieser Spule verursacht wird, auszugleichen.

12. System nach Anspruch 11, dadurch gekennzeichnet, daß diese Spule (25) mit schraubenförmigen Windungen durch Herausarbeiten einer Schraube aus einem zylindrischen Rohrabschnitt und durch axiales Komprimieren dieser Schraube gebildet ist.

13. System nach Anspruch 11 oder 12, dadurch gekennzeichnet, daß die Windungen dieser Spule miteinander mit einem isolierenden Klebstoff verklebt sind, der kalibrierte Glaskügelchen (31) enthält.

14. System nach Anspruch 12 oder 13, dadurch gekennzeichnet, daß ein Zentralabschnitt (32) dieser Spule einen Außendurchmesser aufweist, welcher kleiner als derjenige der beiden benachbarten Endabschnitte (33, 34) ist, um die Homogenität dieses Indikatorfeldes innerhalb dieser Spule zu verbessern.

15. MKR-Abbildungsanlage, mit einem System eines resistiven Magnets, um ein Basismagnetfeld zu erzeugen, das in einem bestimmten Raumbereich homogen sein soll, mit einem System von Gradienten-Spulen (50), um während ausgewählter Sequenzen diesem Basisfeld Gradienten mit verschiedenen, vorbestimmten Feldstärken sowie Orientierungen zu überlagern, mit Sende- und Empfangsmitteln (55, 56) für Funkfrequenzen, um Funkfrequenzsignale in diesem Raumbereich während dieser Sequenzen auszusenden bzw. zu empfangen, sowie mit Rechenmitteln (51), um ausgehend von den Funkfrequenzsignalen, welche durch diese Sende- und Empfangsmittel empfangen werden, ein Bild zu rekonstruieren, wobei dieses System mit resistivem Magnet einen resistiven Hauptmagnet (11), der an einen Kühlfluid-Kreislauf (14) thermisch angekoppelt ist, sowie Mittel (15) für die elektrische Versorgung dieses Magnets umfaßt, wobei die Anlage dadurch gekennzeichnet ist, daß dieses System eines resistiven Magnets ferner einen Hilfsmagnet (13) umfaßt, der an diesen Kühlfluid-Kreislauf angekoppelt ist und durch diese Mittel (15) für die elektrische Versorgung elektrisch versorgt wird, wobei dieser Hilfsmagnet in Vergleich zu diesem Hauptmagnet geringe Abmessungen aufweist, um ein Indikatorfeld zu erzeugen, das für dieses Hauptfeld in einem eingeschränkten Raum repräsentativ ist, daß es ferner Mittel (20) zum Messen des Indikatorfeldes, welche in diesem eingeschränkten Volumen angeordnet sind, sowie eine Regelschleife (19) für diese Versorgungsmittel umfaßt, welche durch diese Mittel zum Messen des Indikatorfeldes gesteuert ist, daß der Sollwert dieser Regelschleife (15a) einstellbar ist, um mehrere Werte des Basisfeldes zu erzeugen, und daß diese Sende- und Empfangs- mittel für Funkfrequenzen so angeordnet sind, daß sie auf verschiedenen Frequenzen (56a) arbeiten, welche jeweils den genannten Werten des Basisfeldes entsprechen, so daß Bilder erhalten werden, die aus verschiedenen MKR-Zuständen gewonnen werden.

FIG_1

EP 0 205 469 B1

# FIG_2

# FIG_3

29
24
22
36
37

# FIG_4

31    30
30
31
25

3

FIG_5